# EUROPÄISCHE PATENTSCHRIFT

(11) **EP 1 682 772 B1**
(45) Veröffentlichungstag und Bekanntmachung des Hinweises auf die Patenterteilung: **06.02.2008**
(21) Anmeldenummer: 04818418.8
(22) Anmeldetag: 10.11.2004
(51) Int. Cl.: F02M 59/46, F02M 51/06, F02M 61/16, H01L 41/047, H01L 41/083

(54) **KONTAKTIERUNGSMATTE F R EINEN AKTOR UND ZUGEH RIGES HER STELLUNGSVERFAHREN**
CONTACT MAT FOR AN ACTUATOR, AND ASSOCIATED PRODUCTION METHOD
TAPIS DE MISE EN CONTACT POUR ACTIONNEUR, ET PROCEDE DE PRODUCTION CORRESPONDANT

(30) Priorität: 12.11.2003 DE 10352772
(43) Veröffentlichungstag der Anmeldung: 26.07.2006
(73) Patentinhaber: Siemens VDO Automotive AG, 93055 Regensburg (DE)
(72) Erfinder: HAUBOLD, Jörg, 09212 Limbach-Oberfrohna (DE); GILG, Horst, 93142 Maxhütte (DE); DÖLLGAST, Bernd, 91054 Erlangen (DE); ZUMSTRULL, Claus, 93128 Regenstauf (DE); SCHUH, Carsten, 85598 Baldham (DE)
(74) Vertreter: Maier, Daniel Oliver
(86) Internationale Anmeldenummer: PCT/EP2004/052910
(87) Internationale Veröffentlichungsnummer: WO 2005/047689

(56) Entgegenhaltungen:
- DE-A1- 10 026 635
- US-B1- 6 307 306
- US-B1- 6 316 863

## Beschreibung

Die Erfindung betrifft eine Kontaktierungsmatte zur elektrische Kontaktierung eines Aktors, insbesondere für einen Piezoaktor zum Antrieb eines Injektors einer Einspritzanlage, gemäß dem Oberbegriff des Anspruchs 1 sowie ein zugehöriges Herstellungsverfahren gemäß dem Oberbegriff von Anspruch 14.

Moderne Einspritzanlagen für Brennkraftmaschinen weisen zur mechanischen Ansteuerung der Injektoren zunehmend Piezoaktoren auf, die im Vergleich zu herkömmlichen elektromagnetischen Aktoren ein besseres dynamisches Verhalten aufweisen. Derartige Piezoaktoren haben herkömmlicherweise einen Piezostapel, in dem eine Vielzahl von schichtförmigen Piezoelementen übereinander angeordnet sind, wobei sich zwischen den einzelnen Piezoelementen jeweils schichtförmige Elektroden befinden. Die elektrische Kontaktierung des Piezostapels erfolgt durch Metallisierungsstreifen, die auf gegenüberliegenden Seitenflächen des Piezostapels angeordnet sind und über die gesamte Länge des Piezostapels reichen, wobei die einzelnen schichtförmigen Elektroden des Piezostapels abwechselnd mit einem der beiden Metallisierungsstreifen verbunden sind. Die beiden Metallisierungsstreifen sind wiederum mit zwei Anschlussstiften verbunden, die auf gegenüberliegenden Seiten des Piezostapels angeordnet sind und stirnseitig aus dem Piezoaktor herausragen, um an der Außenseite eine elektrische Kontaktierung zu ermöglichen.

Aus DE 100 26 635 A1 ist es bekannt, zur elektrischen Verbindung der Metallisierungsstreifen des Piezostapels mit den zugehörigen Anschlussstiften eine Kontaktierungsmatte in Form eines Drahtgeflechts zu verwenden, wobei die Kontaktierungsmatte sogenannte Schussfäden und Kettfäden aufweist. Die Schussfäden sind hierbei parallel zueinander angeordnet, bestehen aus einem leitfähigen Material und verbinden die Metallisierungsstreifen des Piezostapels mit dem jeweils zugehörigen Anschlussstift. Die sogenannten Kettfäden verlaufen dagegen innerhalb der Kontaktierungsmatte rechtwinklig zu den Schussfäden und verbinden diese untereinander, um die Schussfäden mechanisch zu stabilisieren.

Nachteilig an dieser bekannten Kontaktierungsmatte ist die Tatsache, dass es im Betrieb des Piezoaktors zu Brüchen und Rissen in der Kontaktierungsmatte kommen kann.

Der Erfindung liegt deshalb die Aufgabe zugrunde, die vorstehend beschriebene bekannte Kontaktierungsmatte dahingehend zu verbessern, dass im Betrieb des Aktors keine Störungen auftreten.

Darüber hinaus soll die Kontaktierungsmatte auch bei einer kostengünstigen Serienfertigung eines Piezoaktors eine elektrische Kontaktierung des Piezoaktors ermöglichen.

Diese Aufgabe wird, ausgehend von der vorstehend beschriebenen bekannten Kontaktierungsmatte gemäß dem Oberbegriff des Anspruchs 1, durch die kennzeichnenden Merkmale des Anspruchs 1 und - hinsichtlich eines entsprechenden Herstellungsverfahrens - durch die Merkmale des Anspruchs 14 gelöst.

Die Erfindung beruht auf der technischen Erkenntnis, dass die im Betrieb des Aktors auftretenden Risse innerhalb der Kontaktierungsmatte durch die Längenänderung des Piezostapels verursacht werden, wodurch die sogenannten Kettfäden mechanisch belastet werden.

Es ist deshalb im Rahmen der Erfindung vorgesehen, die Querverbindungen zwischen den Drähten der Kontaktierungsmatte nicht durch separate Kettfäder herzustellen, sondern durch die Anschlussstifte des Aktors. Dies ist vorteilhaft, da die Anschlussstifte des Aktors im montierten Zustand innerhalb der Kontaktierungsmatte den größten Abstand zu dem Aktor aufweisen und deshalb von betriebsbedingten Längenänderungen des Aktors am wenigsten beeinflusst werden.

Die erfindungsgemäße Kontaktierungsmatte weist deshalb in herkömmlicher Weise mehrere nebeneinander angeordnete, elektrisch leitfähige Drähte auf, die durch Querverbindungen miteinander verbunden sind, um eine Kontaktierungsmatte zu bilden. Die Querverbindungen zwischen den einzelnen Drähten bestehen hierbei jedoch im Gegensatz zum Stand der Technik aus den Anschlussstiften, die im montierten Zustand zur elektrischen Kontaktierung des Aktors dienen.

Vorzugsweise weisen die Anschlussstifte der erfindungsgemäßen Kontaktierungsmatte Drahtführungen auf, um die einzelnen Drähte mechanische zu führen. Derartige Drahtführungen können beispielsweise aus Abplattungen oder Einkerbungen der Anschlussstifte bestehen, jedoch sind auch andere Gestaltungen der Drahtführungen möglich.

In einem bevorzugten Ausführungsbeispiel der Erfindung sind die Anschlussstifte innerhalb der Kontaktierungsmatte in Längsrichtung der Drähte im wesentlichen äquidistant angeordnet. Dies ist vorteilhaft, da bei fertigen Aktoren desselben Typs die Drahtlänge zwischen den Metallisierungsstreifen des Aktors und dem zugehörigen Anschlussstift konstant ist.

Darüber hinaus umfasst die Erfindung die allgemeine technische Lehre, anstelle von unflexiblen Kettfäden aus Draht ein nachgiebiges Material (z.B. Silikon) zu verwenden, um die einzelnen Drähte der Kontaktierungsmatte zwischen den Anschlussstiften miteinander zu verbinden. Durch die Nachgiebigkeit der Verbindung zwischen den einzelnen Drähten der Kontaktierungsmatte wird vorteilhaft verhindert, dass eine Längenänderung des Piezostapels im späteren Betrieb zu einer Beschädigung der Verbindung führt.

Vorzugsweise ist das nachgiebige Material elastisch und/oder schwingungsdämpfend, um eine Beschädigung im späteren Betrieb zu vermeiden. Es ist jedoch theoretisch auch möglich, dass das nachgiebige Material ein plastisches Verformungsverhalten aufweist. Entscheidend ist lediglich, dass das Material hinreichend nachgiebig ist, um im späteren Betrieb des Aktors die Längenänderung des Aktorkörpers auszugleichen.

In einem bevorzugten Ausführungsbeispiel der Erfindung sind die einzelnen Drähte der Kontaktierungsmatte in das nachgiebige Material eingehüllt, wozu die einzelnen Drähte beispielsweise mit dem nachgiebigen Material umgossen oder umspritzt werden können.

Als Material zur nachgiebigen Verbindung der einzelnen Drähte der Kontaktierungsmatte eignet sich besonders vorteilhaft Silikon oder ein anderes silikonhaltiges Material, da Silikon gute elastische Eigenschaften aufweist und ein gutes Dämpfungsverhalten zeigt. Die Erfindung ist jedoch hinsichtlich des zu verwendenden Materials für die nachgiebige Verbindung der Drähte nicht auf Silikon beschränkt, sondern grundsätzlich auch mit anderen Materialien realisierbar, die ein geeignetes Verformungsverhalten aufweisen.

Vorteilhaft an der Verbindung der einzelnen Drähte zu einer Kontaktierungsmatte ist die gute Handhabbarkeit, da die Kontaktierungsmatte beispielsweise auf eine Vorratsrolle aufgewickelt werden kann, wobei die aufgewickelte Kontaktierungsmatte die Kontaktierung einer Vielzahl von Aktoren ermöglicht. Die Kontaktierungsmatte kann also in einem separaten Herstellungsverfahren vorgefertigt werden, was eine effiziente und kostengünstige Fertigung erlaubt.

Die Erfindung betrifft jedoch nicht nur die vorstehend beschriebene Kontaktierungsmatte, sondern auch einen Aktor mit einer derartigen Kontaktierungsmatte zur elektrischen Verbindung eines Aktorkörpers mit zwei zugehörigen Anschlussstiften.

Vorteilhaft an einem derartigen Aktor mit der erfindungsgemäßen Kontaktierungsmatte ist unter anderem die Tatsache, dass auf einen vollständigen, massiven Verguss des Aktors mit einer Vergussmasse (z.B. Silikon) verzichtet werden kann, da die einzelnen Drähte der Kontaktierungsmatte bereits durch das nachgiebige Material ausreichend gestützt werden.

Es ist jedoch auch bei dem erfindungsgemäßen Aktor grundsätzlich möglich, den Aktor in herkömmlicher Weise massiv und vollständig mit einer Vergussmasse (z.B. Silikon) zu vergie-ßen. Bei einem derartigen vollständigen Vergießen des Aktors unterscheidet sich die Vergussmasse jedoch vorzugsweise hinsichtlich ihrer Materialeigenschaften von dem nachgiebigen Material, das die einzelnen Drähte der Kontaktierungsmatte miteinander verbindet. So sollte das nachgiebige Material zur Verbindung der einzelnen Drähte der Kontaktierungsmatte vorzugsweise ein Benetzungs- und Fliessverhalten aufweisen, das es ermöglicht, das nachgiebige Material durch einen Tauchvorgang auf die Drähte der Kontaktierungsmatte aufzubringen, wobei das nachgiebige Material beim Verfestigen Verbindungsbrücken zwischen den einzelnen Drähten der Kontaktierungsmatte bildet. Im Gegensatz dazu sollte die Vergussmasse für das massive Vergießen des gesamten Aktors vorzugsweise ein Benetzungs- und Fliessverhalten aufweisen, das auch eine Füllung kleiner Hohlräume innerhalb des Aktors sicherstellt.

Die Herstellung der erfindungsgemäßen Kontaktierungsmatte kann also im Rahmen eines separaten Fertigungsverfahrens erfolgen, so dass die fertige Kontaktierungsmatte mit dem Aktorkörper verbunden werden kann.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:
- Figur 1: eine Perspektivansicht eines Piezostapels mit zwei zugehörigen Anschlussstiften und einer Kontaktierungsmatte zur elektrischen Verbindung des Piezostapels mit den Anschlussstiften,
- Figur 2: eine Querschnittsansicht eines Teils der Kontaktierungsmatte aus Figur 1,
- Figur 3: eine schematische Darstellung einer Vorrichtung zur Durchführung des erfindungsgemäßen Herstellungsverfahrens,
- Figur 4: eine schematische Querschnittsansicht des Piezostapels mit den Anschlussstiften und der Kontaktierungsmatte aus Figur 3,
- Figur 5: die erfindungsgemäße Kontaktierungsmatte aus den Figuren 1 und 2 im vormontierten Zustand sowie
- Figur 6: einen Anschlussstift der erfindungsgemäßen Kontaktierungsmatte im Querschnitt mit einem der Drähte.

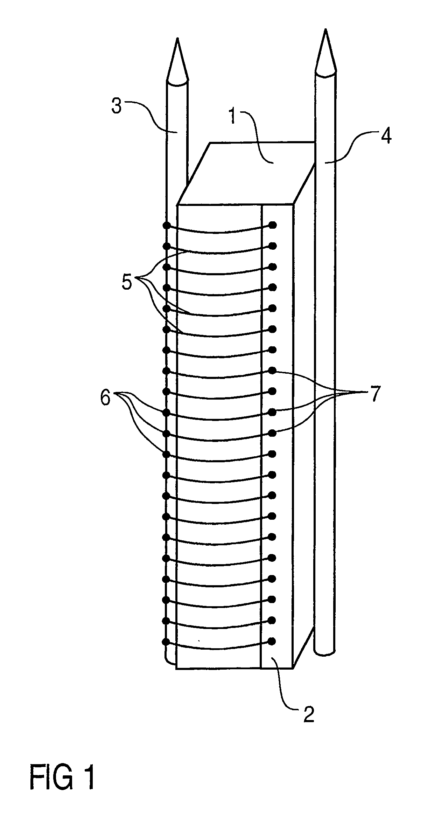

Die Querschnittsansicht in Figur 1 zeigt einen Piezostapel 1, der eine Vielzahl von übereinander angeordneten schichtförmigen Piezoelementen aufweist, wobei zwischen den einzelnen Piezoelementen jeweils eine Elektrodenschicht angeordnet ist.

Auf die in der Zeichnung sichtbare vordere Seitenfläche des Piezostapels 1 ist ein Metallisierungsstreifen 2 aufgebracht, der über die gesamte Länge des Piezostapels durchgeht.

Ein weiterer derartiger Metallisierungsstreifen ist auf die in der Zeichnung nicht sichtbare hintere Seitenfläche des Piezostapels 1 aufgebracht, wobei die einzelnen Elektrodenschichten des Piezostapels 1 abwechselnd mit dem Metallisierungsstreifen 2 und mit dem nicht sichtbaren hinteren Metallisierungsstreifen verbunden sind.

Die elektrische Kontaktierung erfolgt hierbei durch zwei Anschlussstifte 3, 4 die seitlich neben dem Piezostapel 1 angeordnet und parallel zueinander ausgerichtet sind.

Der Anschlussstift 3 ist über eine Vielzahl von elektrisch leitfähigen Drähten 5 mit dem Metallisierungsstreifen 2 verbunden, während der Anschlussstift 4 über verdeckte weitere Drähte mit dem an der Hinterseite des Piezostapels 1 angeordneten und nicht sichtbaren Metallisierungsstreifen verbunden ist.

Die einzelnen Drähte 5 sind hierbei jeweils durch Lötstellen 6, 7 mit dem Anschlussstift 3 und dem Metallisierungsstreifen 2 verbunden.

Vorteilhaft an der Verbindung des Metallisierungsstreifens 2 mit dem Anschlussstift 3 durch eine Vielzahl von Drähten 5 ist die Tatsache, dass die einzelnen Drähte 5 bei der im späteren Betrieb des Piezoaktors auftretenden Längenänderung des Piezostapels 1 individuell der Bewegung des Piezostapels 1 folgen können, wodurch die Gefahr einer Beschädigung der Drähte 5 herabgesetzt wird.

Zum anderen führt die Vielzahl der Drähte 5 zu einer erhöhten Betriebssicherheit, da auch bei einer Unterbrechung der durch einen der Drähte 5 hergestellten elektrischen Verbindung noch eine sichere Kontaktierung durch die anderen Drähte 5 gewährleistet ist.

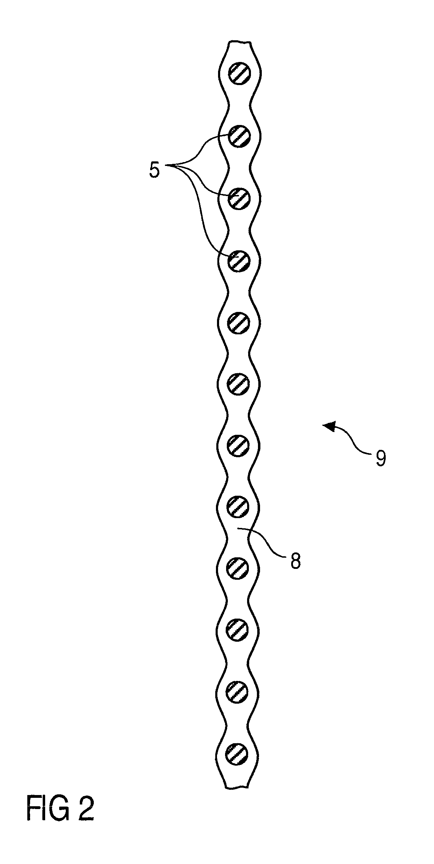

Aus zeichnungstechnischen Gründen sind die einzelnen Drähte 5 in Figur 1 einzeln dargestellt. Aus der Querschnittsansicht in Figur 2 ist jedoch ersichtlich, dass die einzelnen Drähte 5 in ein Material 8 eingebettet sind und eine Kontaktierungsmatte 9 bilden, wobei das Material 8 mechanische Verbindungsbrücken zwischen den einzelnen Drähten 5 bildet.

Bei dem Material 8 handelt es sich hierbei um Silikon, das ein elastisches und schwingungsdämpfendes Verformungsverhalten aufweist, so dass Längenänderungen des Piezostapels 1 im späteren Betrieb des Piezoaktors nicht zu einer Beschädigung der Drähte 5 oder der Lötstellen 6, 7 führen.

Die Umhüllung der Drähte 5 mit dem nachgiebigen Material 8 kann hierbei im Rahmen eines separaten Herstellungsverfahrens erfolgen, bevor die Kontaktierungsmatte 9 mit dem Piezostapel 1 und den Anschlussstiften 3, 4 verbunden wird. Hierzu können die einzelnen Drähte 5 beispielsweise in ein Tauchbad aus verflüssigtem Silikon eingetaucht werden, wobei die Oberflächen der Drähte 5 mit Silikon benetzt werden, so dass sich Verbindungsbrücken zwischen den einzelnen Drähten 5 ausbilden.

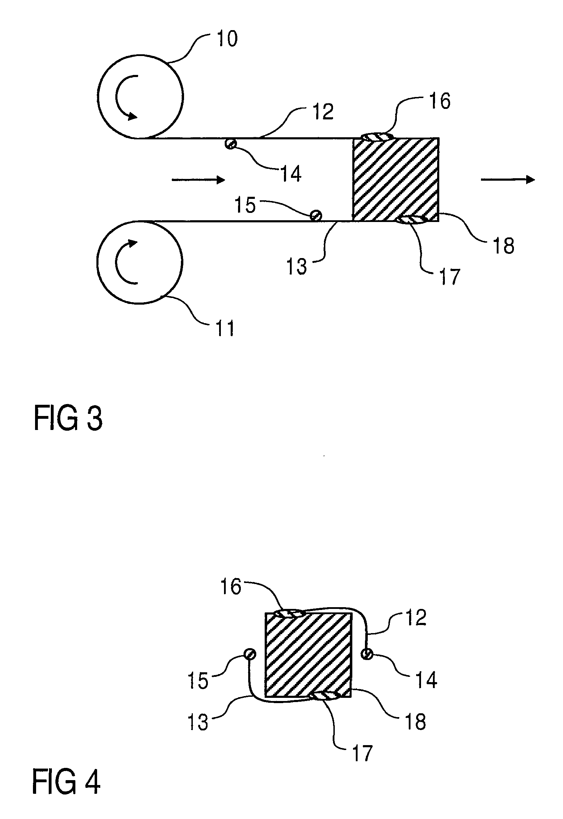

Figur 3 zeigt in stark vereinfachter Form eine Vorrichtung zur Herstellung von Piezoaktoren mit der erfindungsgemäßen Kontaktierungsmatte.

Hierzu weist die Vorrichtung zwei Vorratsrollen 10, 11 auf, auf die jeweils eine fertige Kontaktierungsmatte 12, 13 aufgewickelt ist.

Die Kontaktierungsmatten 12, 13 mit den Anschlussstiften 14, 15 werden dann von den Vorratsrollen 10, 11 abgewickelt und auf die Metallisierungsstreifen 16, 17 eines Piezostapels 18 aufgebracht.

Anschließend wird die Kontaktierungsmatte 12 dann mit dem Metallisierungsstreifen 16 verlötet und daraufhin zwischen dem Anschlussstift 14 und der Vorratsrolle 10 getrennt.

In ähnlicher Weise wird die Kontaktierungsmatte 13 mit dem Metallisierungsstreifen 17 verlötet und dann zwischen dem Anschlussstift 15 und der Vorratsrolle 11 getrennt.

In einem nächsten Arbeitsschritt wird die Kontaktierungsmatte 12 dann um den Piezostapel 18 in Uhrzeigerrichtung herum geschlagen, bis der Anschlussstift 14 die in Figur 4 gezeigte Endstellung einnimmt.

In ähnlicher Weise wird auch die Kontaktierungsmatte 13 in Uhrzeigerrichtung um den Piezostapel 18 herumgeschlagen, bis der Anschlussstift 15 die in Figur 4 gezeigte Endstellung einnimmt.

Schließlich kann die gesamte Piezoeinheit dann noch massiv vergossen werden, was bekannt ist und deshalb zur Vereinfachung nicht weiter beschrieben wird.

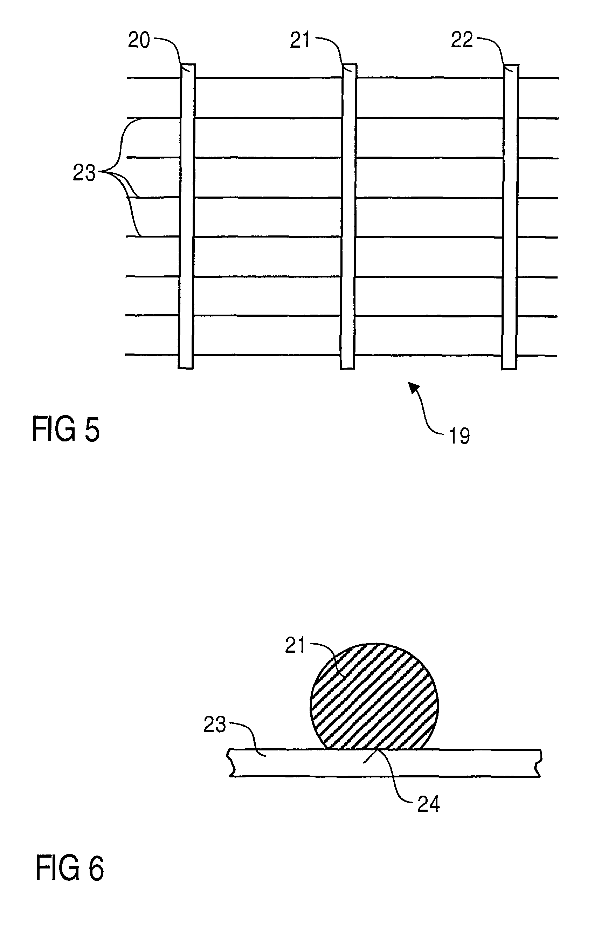

Figur 5 zeigt ferner die Kontaktierungsmatte 19 im vormontierten Zustand mit drei Anschlussstiften 20, 21, 22 und mehreren Drähten 23, wobei die Anschlussstifte 20-22 mit den Drähten 23 verlötet sind und rechtwinklig zu den Drähten 23 verlaufen. Die Kontaktierungsmatte 19 kann somit vorgefertigt werden, wobei eine Lagerung der Kontaktierungsmatte 19 auf einer Vorratsrolle möglich ist, wie vorstehend beschrieben wurde.

Figur 6 zeigt schließlich einen Querschnitt durch den Anschlussstift 21 der Kontaktierungsmatte 19. Daraus ist ersichtlich, dass der Anschlussstift 21 im Bereich des Drahts 23 eine Abplattung 24 aufweist, welche die Verlötung des Drahtes 23 mit dem Anschlussstift 21 erleichtert.

Die Erfindung ist nicht auf die vorstehend beschriebenen bevorzugten Ausführungsbeispiele beschränkt. Vielmehr ist eine Vielzahl von Varianten und Abwandlungen möglich, die ebenfalls von dem Erfindungsgedanken Gebrauch machen und deshalb in den Schutzbereich fallen wie er in den beigefügten Ansprüchen definiert ist.

## Patentansprüche

1. Kontaktierungsmatte (9, 19) zur elektrischen Kontaktierung eines Aktors, insbesondere eines Piezoaktors für einen Injektor einer Einspritzanlage, mit
- mehreren nebeneinander angeordneten elektrisch leitfähigen Drähten (5, 23) und
- mehreren mechanischen Querverbindungen zwischen den einzelnen Drähten (5, 23),
**dadurch gekennzeichnet,**
**dass** die Querverbindungen aus jeweils einem Anschlussstift (3, 4, 20-22) des Aktors bestehen.

2. Kontaktierungsmatte (9, 19) nach Anspruch 1,
**dadurch gekennzeichnet,**
**dass** die Anschlussstifte (3, 4, 20-22) Drahtführungen aufweisen, um die Drähte (5, 23) mechanisch zu führen.

3. Kontaktierungsmatte (9, 19) nach Anspruch 2,
**dadurch gekennzeichnet,**
**dass** die Drahtführungen aus einer Abplattung (24) der Anschlussstifte (3, 4, 20-22) bestehen.

4. Kontaktierungsmatte (9, 19) nach Anspruch 2 oder 3,
**dadurch gekennzeichnet,**
**dass** die Drahtführungen aus Einkerbungen in den Anschlussstiften (3, 4, 20-22) bestehen, wobei die Einkerbungen in Längsrichtung der Drähte (5, 23) verlaufen.

5. Kontaktierungsmatte (9, 19) nach einem der vorhergehenden Ansprüche,
**dadurch gekennzeichnet,**
**dass** die Anschlussstifte (3, 4, 20-22) in Längsrichtung der Drähte (5, 23) im wesentlichen äquidistant angeordnet sind.

6. Kontaktierungsmatte (9, 19) nach einem der vorhergehenden Ansprüche,
**dadurch gekennzeichnet,**
**dass** die Anschlussstifte (3, 4, 20-22) in Längsrichtung der Drähte (5, 23) in einem Abstand angeordnet sind, der größer ist als die Länge der Drähte (5, 23) bei einem fertig kontaktierten Aktor.

7. Kontaktierungsmatte (9, 19) nach einem der vorhergehenden Ansprüche,
**dadurch gekennzeichnet,**
**dass** die Anschlussstifte (3, 4, 20-22) durch eine Lötverbindung mit den Drähten (5, 23) verbunden sind.

8. Kontaktierungsmatte (9, 19) nach einem der vorhergehenden Ansprüche,
**dadurch gekennzeichnet,**
**dass** die einzelnen Drähte (5, 23) zwischen den Anschlussstiften (3, 4, 20-22) durch ein nachgiebiges Material (8) miteinander verbunden sind.

9. Kontaktierung nach Anspruch 8,
**dadurch gekennzeichnet,**
**dass** das nachgiebige Material (8) elastisch und/oder schwingungsdämpfend ist.

10. Kontaktierung nach Anspruch 8 oder 9,
**dadurch gekennzeichnet,**
**dass** die einzelnen Drähte (5, 23) in das nachgiebige Material (8) eingehüllt sind.

11. Kontaktierung nach einem der vorhergehenden Ansprüche,
**dadurch gekennzeichnet,**
**dass** die einzelnen Drähte (5, 23) mit dem nachgiebigen Material (8) umgossen oder umspritzt sind.

12. Aktor, insbesondere Piezoaktor für einen Injektor einer Einspritzanlage, mit einer Kontaktierungsmatte (9, 19) nach einem der vorhergehenden Ansprüche zur elektrischen Verbindung eines Piezostapels (18) mit zwei Anschlussstiften (3, 4, 20-22).

13. Injektor für eine Einspritzanlage mit einem Aktor nach Anspruch 12.

14. Herstellungsverfahren für eine Kontaktierungsmatte (9, 19) zur elektrischen Kontaktierung eines Aktors, mit den folgenden Schritten:
- Anordnung mehrerer elektrisch leitfähiger Drähte (5, 23) nebeneinander,
- Mechanische Verbindung der einzelnen Drähte (5, 23) miteinander durch mehrere Querverbindungen,
**dadurch gekennzeichnet,**
**dass** die Querverbindungen aus jeweils einem Anschlussstift (3, 4, 20-22) des Aktors bestehen.

15. Herstellungsverfahren nach Anspruch 14,
**dadurch gekennzeichnet,**
**dass** die Anschlussstifte (3, 4, 20-22) durch Lötverbindungen mit den Drähten (5, 23) verbunden werden.

16. Herstellungsverfahren nach Anspruch 14 oder 15,
**dadurch gekennzeichnet,**
**dass** die Drähte (5, 23) von einer oder mehreren Vorratsrollen (10, 11) abgewickelt werden, um die Drähte (5, 23) nebeneinander anzuordnen.

17. Herstellungsverfahren nach einem der Ansprüche 14 bis 16,
**gekennzeichnet durch**
folgende Schritte:
- Befestigung der Drähte (5, 23) einer ersten Kontaktierungsmatte (9, 19) an einem ersten Kontaktstreifen (2) eines Aktors,
- Trennung der Drähte (5, 23) der ersten Kontaktierungsmatte (9, 19) zwischen den beiden Anschlussstiften (3, 4, 20-22), die dem Aktor am nächsten liegen,
- Befestigung der Drähte (5, 23) einer zweiten Kontaktierungsmatte (9, 19) an einem zweiten Kontaktstreifen desselben Aktors,
- Trennung der Drähte (5, 23) der zweiten Kontaktierungsmatte (9, 19) zwischen den beiden Anschlussstiften (3, 4, 20-22), die dem Aktor am nächsten liegen.

18. Herstellungsverfahren nach einem der Ansprüche 14 bis 17,
**dadurch gekennzeichnet,**
**dass** die Drähte (5, 23) der Kontaktierungsmatte (9, 19) zwischen den Anschlussstiften (3, 4, 20-22) durch ein nachgiebiges Material (8) miteinander verbunden werden.

19. Herstellungsverfahren nach Anspruch 18,
**dadurch gekennzeichnet,**
**dass** das nachgiebige Material (8) elastisch und/oder schwingungsdämpfend ist.

20. Herstellungsverfahren nach Anspruch 18 oder 19,
**dadurch gekennzeichnet,**
**dass** die einzelnen Drähte (5, 23) mit dem nachgiebigen Material (8) umhüllt werden.

21. Herstellungsverfahren nach einem der Ansprüche 18 bis 20,
**dadurch gekennzeichnet,**
**dass** die einzelnen Drähte (5, 23) mit dem nachgiebigen Material (8) umgossen oder umspritzt werden.

22. Herstellungsverfahren nach einem der Ansprüche 18 bis 21,
**dadurch gekennzeichnet,**
**dass** die einzelnen Drähte (5, 23) untereinander verbunden werden, indem die Drähte (5, 23) in das verflüssigte nachgiebige Material (8) eingetaucht werden, wobei das verflüssigte Material die Drähte (5, 23) benetzt und zwischen den Drähten (5, 23) Verbindungsbrücken bildet.

23. Herstellungsverfahren nach Anspruch 22,
**dadurch gekennzeichnet,**
**dass** die Drähte (5, 23) in das verflüssigte nachgiebige Material (8) eingetaucht werden, bevor die Drähte (5, 23) mit dem Aktorkörper und den zugehörigen Anschlussstiften (3, 4, 20-22) verbunden werden.

24. Herstellungsverfahren nach Anspruch 23,
**dadurch gekennzeichnet,**
**dass** die Drähte (5, 23) zusammen mit dem Aktorkörper und den Anschlussstiften (3, 4, 20-22) in das verflüssigte Material eingetaucht werden, nachdem die Drähte (5, 23) mit dem Aktorkörper und den zugehörigen Anschlussstiften (3, 4, 20-22) verbunden wurden.

25. Herstellungsverfahren nach einem der Ansprüche 17 bis 24,
**dadurch gekennzeichnet,**
**dass** der Aktorkörper mit den zugehörigen Anschlussstiften (3, 4, 20-22) und der Kontaktierungsmatte (9, 19) mit einer Vergussmasse vergossen wird.

## Claims

1. Contact mat (9, 19) for electrical contacting of an actuator, especially of a piezo actuator for an injector of an injection system, with
- a number of electrically-conductive wires (5, 23) arranged next to one another and
- a number of mechanical transversal connections between the individual wires (5, 23),
**characterised in that**
the transversal connections consist in each case of one terminal post (3, 4, 20-22) of the actuator.

2. Contact mat (9, 19) in accordance with claim 1,
**characterised in that**
the terminal posts (3, 4, 20-22) feature wire guides to mechanically guide the wires (5, 23).

3. Contact mat (9, 19) in accordance with claim 2,
**characterised in that**
the wire guides consist of a flattening (24) of the terminal posts (3, 4, 20-22).

4. Contact mat (9, 19) in accordance with claim 2 or 3,
**characterised in that**
the wire guides consist of nicks in the terminal posts (3, 4, 20-22), with the nicks running in the longitudinal direction of the wires (5, 23).

5. Contact mat (9, 19) in accordance with one of the preceding claims,
**characterised in that**
the terminal posts (3, 4, 20-22) are arranged essentially equidistantly in the longitudinal direction of the wires (5, 23).

6. Contact mat (9, 19) in accordance with one of the preceding claims,
**characterised in that**
the terminal posts (3, 4, 20-22) are arranged in the longitudinal direction of the wires (5, 23) at a distance which is greater than the length of the wires (5, 23) for a complete contacted actuator.

7. Contact mat (9, 19) in accordance with one of the preceding claims,
**characterised in that**
the terminal posts (3, 4, 20-22) are connected to the wires (5, 23) by a solder connection.

8. Contact mat (9, 19) in accordance with one of the preceding claims,
**characterised in that**
the individual wires (5, 23) between the terminal posts (3, 4, 20-22) are connected to one another by a flexible material (8).

9. Contacting in accordance with claim 8,
**characterised in that**
the flexible material (8) is elastic and/or vibration-damping.

10. Contacting in accordance with claim 8 or 9,
**characterised in that**
the individual wires (5, 23) are encapsulated in the flexible material (8).

11. Contacting in accordance with one of the preceding claims,
**characterised in that**,
the individual wires (5, 23) are moulded within or injection coated with the flexible material (8).

12. Actuator, especially a piezo actuator for an injector of an injection system, with a contact mat (9, 19) in accordance with one of the preceding claims, for electrical connection of a piezo stack (18) with two terminal posts (3, 4, 20-22).

13. Injector for an injection system with an actuator in accordance with claim 12.

14. Production method for a contact mat (9, 19) for electrical contacting of an actuator, with the following steps:
- Arrangement of a number of electrically-conductive wires (5, 23) next to one another,
- Mechanical connection of the individual wires (5, 23) to one another by a number of transversal connections,
**characterised in that**
the transversal connections consist in each case of one terminal post (3, 4, 20-22) of the actuator.

15. Production method in accordance with claim 14,
**characterised in that**
the terminal posts (3, 4, 20-22) are connected to the wires (5, 23) by solder connections.

16. Production method in accordance with claim 14 or 15,
**characterised in that**
the wires (5, 23) are unwound from one or more feed rolls (10, 11), to arrange the wires (5, 23) next to one another.

17. Production method in accordance with one of claims 14 to 16,
**characterised by**
the following steps:
- Attaching the wires (5, 23) of a first contact mat (9, 19) to a first contact strip (2) of an actuator,
- Separating the wires (5, 23) of the first contact mat (9, 19) between the two terminal posts (3, 4, 20-22) which are closest to the actuator,
- Attaching the wires (5, 23) of a second contact mat (9, 19) to a second contact strip of the same actuator,
- Separating the wires (5, 23) of the second contact mat (9, 19) between the two terminal posts (3, 4, 20-22) which are closest to the actuator.

18. Production method in accordance with one of claims 14 to 17,
**characterised in that**
the wires (5, 23) of the contact mat (9, 19) between the terminal posts (3, 4, 20-22) are connected to one another by a flexible material (8).

19. Production method in accordance with claim 18,
**characterised in that**
the flexible material (8) is elastic and/or vibration-damping.

20. Production method in accordance with claim 18 or 19,
**characterised in that**
the individual wires (5, 23) are encapsulated with the flexible material (8).

21. Production method in accordance with one of claims 18 to 20,
**characterised in that**
the individual wires (5, 23) are moulded within or injection coated with the flexible material (8).

22. Production method in accordance with one of claims 18 to 21,
**characterised in that**
the individual wires (5, 23) are interconnected by the wires (5, 23) being immersed in the liquefied flexible material (8) with the liquefied material coating the wires (5, 23) and forming connection bridges between the wires (5, 23).

23. Production method in accordance with claim 22,
**characterised in that**
the wires (5, 23) are immersed in the liquefied flexible material (8) before the wires (5, 23) are connected to the actuator body and the associated terminal posts (3, 4, 20-22).

24. Production method in accordance with claim 23,
**characterised in that**
the wires (5, 23) together with the actuator body and the terminal posts (3, 4, 20-22) are immersed in the liquefied material after the wires (5, 23) have been connected to the actuator body and the associated terminal posts (3, 4, 20-22).

25. Production method in accordance with one of claims 17 to 24,
**characterised in that**
the actuator body with the associated terminal posts (3, 4, 20-22) and the contact mat (9, 19) is cast with a casting compound.

## Revendications

1. Nappe de contact (9, 19) pour la mise en contact électrique d'un actionneur, en particulier d'un actionneur piézo-électrique pour un injecteur d'une installation d'injection, comprenant
- plusieurs fils conducteurs de l'électricité (5, 23), disposés les uns à côté des autres et
- plusieurs liaisons transversales mécaniques entre les différents fils (5, 23),
**caractérisée en ce que**,
les liaisons transversales sont constituées chacune par une broche de connexion (3, 4, 20, 22) de l'actionneur.

2. Nappe de contact (9, 19) selon la revendication 1, **caractérisée en ce que**,
les broches de connexion (3, 4, 20-22) présentent des guidages de fils pour guider mécaniquement les fils (5, 23).

3. Nappe de contact (9, 19) selon la revendication 2, **caractérisée en ce que**,
les guidages de fils sont constitués par un aplatissement (24) des broches de connexion (3, 4, 20-22).

4. Nappe de contact (9, 19) selon la revendication 2 ou 3,
**caractérisée en ce que**,
les guidages de fils sont constitués par des encoches formées dans les broches de connexion (3, 4, 20-22), les encoches s'étendant dans la direction longitudinale des fils (5, 23).

5. Nappe de contact (9, 19) selon une des revendications précédentes,
**caractérisée en ce que**,
les broches de connexion (3, 4, 20-22) sont sensiblement équidistantes dans la direction longitudinale des fils (5, 23).

6. Nappe de contact (9, 19) selon une des revendications précédentes,
**caractérisée en ce que**,
les broches de connexion (3, 4, 20-22) sont disposées à une distance d'écartement dans la direction longitudinale des fils (5,23) qui est plus grande que la longueur des fils (5, 23) dans un actionneur mis en contact fini.

7. Nappe de contact (9, 19) selon une des revendications précédentes,
**caractérisée en ce que**,
les broches de connexion (3, 4, 20-22) sont assemblées aux fils (5,23) par une liaison soudée.

8. Nappe de contact (9, 19) selon une des revendications précédentes,
**caractérisée en ce que**,
les différents fils (5,23) sont assemblés entre eux entre les broches de connexion (3, 4, 20-22) par une matière déformable (8).

9. Mise en contact selon la revendication 8,
**caractérisée en ce que**,
la matière déformable (8) est élastique et/ou anti-vibratoire.

10. Mise en contact selon la revendication 8 ou 9,
**caractérisée en ce que**,
les différents fils (5, 23) sont enveloppés dans la matière déformable.

11. Mise en contact selon une des revendications précédentes,
**caractérisée en ce que**,
les différents fils (5,23) sont traités avec la matière déformable par coulée ou par surmoulage.

12. Actionneur, en particulier actionneur piézo-électrique pour un injecteur d'une installation d'injection, comprenant une nappe de contact (9, 19) selon une des revendications précédentes pour la connexion électrique d'un empilement piézo-électrique (18) possédant deux broches de connexion (3, 4, 20-22).

13. Injecteur pour une installation d'injection équipé d'un actionneur selon la revendication 12.

14. Procédé de fabrication pour une nappe de contact (9, 19) destinée à la mise en contact électrique d'un actionneur, comprenant les étapes suivantes :
- disposer plusieurs fils conducteurs de l'électricité (5, 23) les uns à côté des autres,
- assembler mécaniquement les différents fils (5, 23) les uns aux autres par plusieurs liaisons transversales,
**caractérisé en ce que**,
les liaisons transversales sont constituées chacune par une broche de connexion (3, 4, 20-22) de l'actionneur.

15. Procédé de fabrication selon la revendication 14,
**caractérisé en ce que**,
les broches de connexion (3, 4, 20-22) sont assemblées aux fils (5, 23) par des liaisons soudées.

16. Procédé de fabrication selon la revendication 14 ou 15,
**caractérisé en ce que**,
les fils (5, 23) sont déroulés d'un ou plusieurs rouleaux d'alimentation (10, 11) pour disposer les fils (5, 23) les uns à côté des autres.

17. Procédé de fabrication selon une des revendications 14 à 16,
**caractérisé par** les étapes suivantes :
- fixer les fils (5, 23) d'une première nappe de contact (9, 19) à une première bande de contact (2) d'un actionneur,
- couper les fils (5, 23) de la première nappe de contact (9, 19) entre les deux broches de connexion (3, 4, 20-22) qui sont les plus proches de l'actionneur;
- fixer les fils (5, 23) d'une deuxième nappe de contact (9, 19) à une deuxième bande de contact du même actionneur,
- couper les fils (5, 23) de la deuxième nappe de contact (9,19) entre les deux broches de connexion (3, 4, 20-22) qui sont les plus proche de l'actionneur.

18. Procédé de fabrication selon une des revendications 14 à 17
**caractérisé en ce que**,
les fils (5, 23) de la nappe de contact (9,19) sont assemblés entre eux par une matière déformable (8) entre les broches de connexion (3, 4, 20-22).

19. Procédé de fabrication selon la revendication 18,
**caractérisé en ce que**,
la matière déformable (8) est élastique et/ou anti-vibratoire.

20. Procédé de fabrication selon la revendication 18 ou 19,
**caractérisé en ce que**,
les différents fils (5, 23) sont enrobés avec la matière déformable (8).

21. Procédé de fabrication selon une des revendications 18 à 20,
**caractérisé en ce que**,
les différents fils (5, 23) sont traités avec la matière déformable par coulée ou par surmoulage.

22. Procédé de fabrication selon une des revendications 18 à 21,
**caractérisé en ce que**,
les différents fils (5, 23) sont assemblés entre eux par le fait que les fils (5, 23) sont plongés dans la matière déformable (8) liquéfiée, la matière liquéfiée mouillant les fils (5, 23) et formant des ponts de liaison entre les fils (5, 23).

23. Procédé de fabrication selon la revendication 22,
**caractérisé en ce que**,
les fils (5, 23) sont plongés dans la matière déformable liquéfiée (8) avant que les fils (5, 23) ne soient assemblés au corps de l'actionneur et à ses broches de connexion (3, 4, 20-22).

24. Procédé de fabrication selon la revendication 23,
**caractérisé en ce que**,
les fils sont plongés dans la matière liquéfiée simultanément avec le corps de l'actionneur et avec les broches de connexion (3, 4, 20-22) après que les fils (5, 23) ont été assemblés au corps de l'actionneur et à ses broches de connexion (3, 4, 20-22).

25. Procédé de fabrication selon une des revendications 17 à 24,
**caractérisé en ce que**,
le corps de l'actionneur, avec ses broches de connexion (3, 4, 20-22) et la nappe de contact (9, 19) est enrobé avec une masse d'enrobage.
